# EUROPÄISCHE PATENTANMELDUNG

(11) **EP 1 615 075 A1**
(43) Veröffentlichungstag der Anmeldung: **11.01.2006**
(21) Anmeldenummer: 04015871.9
(22) Anmeldetag: 06.07.2004
(51) Int. Cl.: G03F 7/12, G03F 7/20, B41C 1/14

(54) **Vorrichtung zur Herstellung von Siebdruckschablonen**

(71) Anmelder: CST GmbH, 47809 Krefeld (DE)
(72) Erfinder: Kesper, Peter, 47800 Krefeld (DE)
(74) Vertreter: Cohausz & Florack

(57) **Zusammenfassung**

Die Erfindung betrifft eine Vorrichtung (1) zur Herstellung von Siebdruckschablonen für Drucksiebe (2), insbesondere für Flach- und/oder Runddrucksiebe, mit einer Aufnahme für die Siebdruckschablone und mindestens einem relativ zur Siebdruckschablone verfahrbaren Strukturierungskopf (3, 4), wobei der Strukturierungskopf (3, 4) das Schablonenmaterial der Siebdruckschablone strukturiert oder zumindest für eine Strukturierung vorbereitet. Die Vorteile von Verfahren, die mit einer unmittelbaren Belichtung arbeiten und von Verfahren, die zunächst eine Belichtungsmaske herstellen, werden in einer Vorrichtung dadurch miteinander vereinbart, dass erfindungsgemäß mindestens zwei Strukturierungsköpfe (3, 4) vorgesehen sind, ein erster Strukturierungskopf (3) eine Belichtungseinrichtung aufweist und ein zweiter Strukturierungskopf (4) eine Materialauftragseinrichtung aufweist.

**Für die Veröffentlichung mit Zusammenfassung wird die einzige Figur vorgeschlagen.**

## Beschreibung

Die Erfindung betrifft eine Vorrichtung zur Herstellung von Siebdruckschabloben für Drucksiebe, insbesondere für Flach- und/oder Runddrucksiebe, mit einer Aufnahme für die Siebdruckschablone und mindestens einem relativ zur Siebdruckschablone verfahrbaren Strukturierungskopf, wobei der Strukturierungskopf das Schablonenmaterial der Siebdruckschablone strukturiert oder zumindest für eine Strukturierung vorbereitet.

Derartige Vorrichtungen sind aus dem Stand der Technik in einer Vielzahl von Ausgestaltungen bekannt. Es ist beispielsweise bekannt, dass eine derartige Vorrichtung zur unmittelbaren Belichtung eines lichtempfindlichen Schablonenmaterials einen Laser aufweist, der derart aus- und angeschaltet wird, dass dieser das Schablonenmaterial punktgenau belichtet. Eine Weiterentwicklung einer derartigen punktgenauen Belichtung mit einer Lichtquelle ist beispielsweise aus der EP 0 953 877 A1 bekannt. Bei diesem bekannten Verfahren wird die Belichtungsgeschwindigkeit gegenüber einem Lasersystem dadurch erheblich vergrößert, dass eine starke Lichtquelle über ein mikromechanisches Spiegelsystem auf das lichtempfindliche Schablonenmaterial abgebildet wird.

Alternativ zu den beschriebenen Verfahren, die eine unmittelbare Belichtung des Schablonenmaterials vorsehen, sind verschiedene Verfahren bekannt, bei denen das lichtempfindliche Schablonenmaterial zunächst mit einer lichtundurchlässigen Maske abgedeckt wird und in einem zweiten Schritt mit Hilfe einer starken Lichtquelle flächig belichtet wird. Insbesondere kann hierbei verwiesen auf das aus der EP 1 049 916 A1 bekannte Verfahren, bei dem die Maske dadurch hergestellt wird, dass eine im Wesentlichen aus Wachs bestehende Schicht punktgenau von einem Düsenkopf auf das Schablonenmaterial aufgetragen wird.

Beide bekannten Verfahren weisen spezifische Vor- und Nachteile auf. Da als Schablonenmaterial in der Regel ein Positivresist verwendet wird, ist es auch bei kleinen Flächenanteilen des Druckmotivs bezogen auf die Gesamtfläche des Siebes notwendig, die gesamte Siebfläche zu belichten. Dies bedeutet, dass die Zeit, die im Falle einer punktgenauen Belichtung mit einer Lichtquelle zur Strukturierung einer Siebfläche notwendig ist, fast ausschließlich von der Siebfläche abhängt und insbesondere unabhängig von der Größe des druckenden Bereiches ist. Im Gegensatz hierzu ist die Technologie, die zur Strukturierung des Schablonenmaterials mit einem Materialauftrag arbeitet, bezogen auf die Größe der Druckfläche eher langsam. Allerdings ist die Bearbeitungszeit in diesem Fall im Wesentlichen unabhängig von der Siebgröße und fast ausschließlich abhängig von der Größe des zu druckenden Motivs, da die anschließende Belichtung in der Regel vollflächig mit einer großen Belichtungslampe vorgenommen wird.

Es soll an dieser Stelle ergänzend noch erwähnt werden, dass neben den vorstehend im Einzelnen erläuterten Techniken zur Strukturierung des Schablonenmaterials einer Siebdruckschablone weitere Techniken bekannt sind. Beispielsweise ist auch bekannt der Auftrag einer reaktiven Tinte, die im Wesentlichen ohne Belichtung eine Strukturierung des Schablonenmaterials ermöglicht (vgl. europäische Patentanmeldung, Aktenzeichen 03 016 055). Es ist weiterhin bekannt, das Schablonenmaterial zunächst unabhängig von dem Drucksieb zu strukturieren bzw. für eine Strukturierung vorzubereiten und anschließend auf das Drucksieb zu transferieren.

Ausgehend von dem zuvor beschriebenen Stand der Technik liegt der vorliegenden Erfindung die Aufgabe zugrunde, eine Vorrichtung zur Herstellung von Siebdruckschablonen für Drucksiebe zur Verfügung zu stellen, die die Vorteile der bekannten Technologien zur Strukturierung des Schablonenmaterials in einer einzigen Vorrichtung vereinigt.

Erfindungsgemäß ist die zuvor hergeleitete und aufgezeigte Aufgabe dadurch gelöst, dass mindestens zwei Strukturierungsköpfe vorgesehen sind, ein erster Strukturierungskopf eine Belichtungseinrichtung aufweist und ein zweiter Strukturierungskopf eine Materialauftragseinrichtung aufweist. Erfindungsgemäß ist damit gewährleistet, dass je nach Flächenanteil der Druckfläche an der Gesamtfläche des Drucksiebes die geeignete Technologie ausgewählt werden kann, ohne das die Notwendigkeit zur Anschaffung einer zweiten Vorrichtung zur Herstellung von Siebdruckschablonen für Drucksiebe besteht. Beispielsweise ermöglicht es die erfindungsgemäße Vorrichtung Siebdruckschablonen für unterschiedliche Farben eines großflächigen Motivs auf ein und derselben Vorrichtung herzustellen, wobei ein Sieb für eine großflächig aufzutragende Farbe unter Verwendung des ersten Strukturierungskopfes mit einer Belichtungseinrichtung strukturiert wird und ein zweites Sieb für eine lediglich kleinflächig aufzutragende Farbe mit Hilfe des zweiten Strukturierungskopfes, der eine Materialauftragseinrichtung aufweist, strukturiert wird. Damit ermöglicht eine erfindungsgemäße Vorrichtung eine kostengünstige, da auf einer einzigen Vorrichtung verwirklichbare, Herstellung von Drucksieben mit unterschiedlichen Flächenanteilen der Druckflächen, wobei gleichzeitig eine hohe Präzision bei der Passgenauigkeit der Siebe für unterschiedliche Druckfarben eines einzigen Druckmotives gewährleistet ist, da beide auf ein und derselben Vorrichtung hergestellt werden.

Die erfindungsgemäße Vorrichtung ist weiter dahingehend vorteilhaft, als das sie die Verwendung des eine Materialauftragseinrichtung aufweisenden Strukturierungskopfes nur für kleinere Flächenanteile der Druckflächen ermöglicht, wodurch der Anteil der Kosten für die Verbrauchsmaterialien dieses Strukturierungskopfes minimiert werden.

Eine erste vorteilhafte Ausgestaltung erfährt die erfindungsgemäße Vorrichtung dadurch, dass die Belichtungseinrichtung ein mikromechanisches Spiegelsystem aufweist. Eine derartige Ausgestaltung der erfindungsgemäßen Vorrichtung führt dazu, dass der eine Belichtungseinrichtung aufweisende Strukturierungskopf eine Belichtung der jeweiligen Flächen mit hoher Präzision und Geschwindigkeit ermöglicht. Zu den Einzelheiten einer ein mikromechanisches Spiegelsystem aufweisenden Belichtungseinrichtung wird insbesondere auf die ebenfalls auf die Anmelderin zurückgehende EP 0 953 877 A1 verwiesen.

Dadurch, dass die Materialauftragseinrichtung ein Düsenkopf zum Auftrag von Wachs oder Tinte zur Herstellung einer Belichtungsmaske auf den Schablonenmaterial aufweist, ist gewährleistet, dass der Materialauftrag unter Verwendung etablierter Technologien mit vergleichsweiser hoher Geschwindigkeit und guter Präzision möglich ist. Zu der Ausgestaltung einer derartigen Materialauftragseinrichtung wird beispielsweise auf die ebenfalls auf die Anmelderin zurückgehende EP 1 049 916 A1 verwiesen.

Eine besonders einfache mechanische Ausgestaltung wird dadurch gewährleistet, dass die Strukturierungsköpfe auf einer gemeinsamen Halterung angeordnet sind. Bei einer derartigen Ausgestaltung werden beide Strukturierungsköpfe relativ zu der Siebdruckschablone gemeinsam verfahren, was getrennte Antriebe für die Strukturierungsköpfe überflüssig macht.

Dadurch, dass die Strukturierungsköpfe auf getrennten Halterungen angeordnet sind, kann unter Umständen eine höhere mechanische Präzision bei der Steuerung der relativen Position von Strukturierungskopf und Siebdruckschablone gewährleistet werden. Auch können die Antriebe in diesem Fall kleiner und leichter ausgebildet werden.

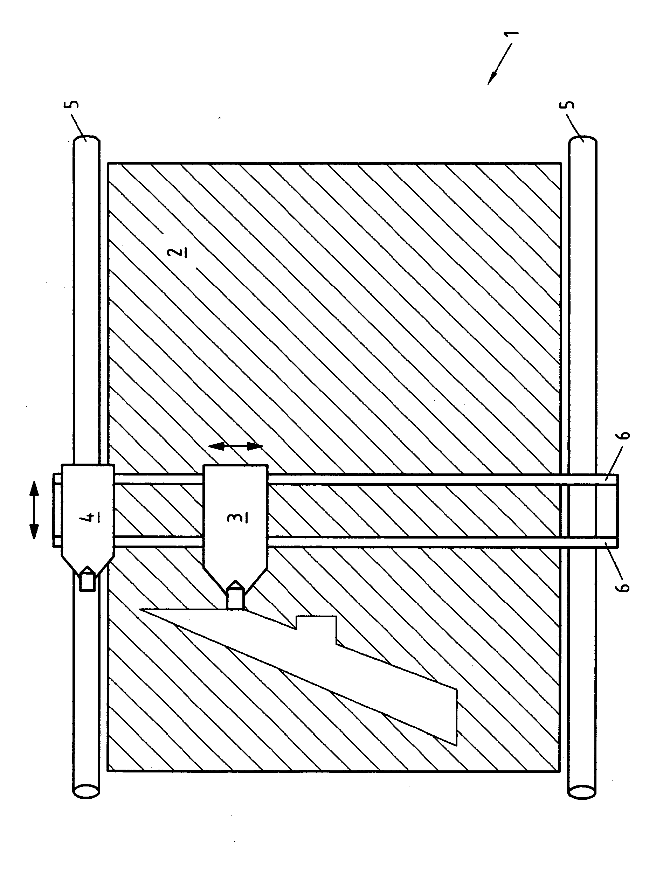

Es existieren nun eine Vielzahl von Möglichkeiten, die erfindungsgemäße Vorrichtung auszugestalten und weiterzubilden. Hierzu wird einerseits verwiesen auf die dem Patentanspruch 1 nachgeordneten Patentansprüche andererseits auf die nachfolgende Beschreibung eines Ausführungsbeispiels in Verbindung mit der Zeichnung.

In der Zeichnung zeigt die einzige Figur ein Ausführungsbeispiel einer Vorrichtung zur Herstellung von Siebdruckschablonen in einer Aufsicht.

Die in der einzigen Figur dargestellte Vorrichtung zur Herstellung von Siebdruckschablonen für ein Flachdrucksieb 2 weist eine im Einzelnen nicht dargestellte Aufnahme für das Flachdrucksieb 2 auf. Die Vorstufe der Siebdruckschablone wird in dem dargestellten Ausführungsbeispiel durch eine unmittelbar auf den Flachdrucksieb 2 angeordnete, im Einzelnen nicht dargestellte lichtempfindliche Beschichtung gebildet. Das Ausführungsbeispiel einer Vorrichtung 1 zur Herstellung von Siebdruckschablonen weist zwei relativ zur Siebdruckschablone verfahrbare Strukturierungsköpfe 3, 4 auf. Beide Strukturierungsköpfe 3, 4 dienen zur Strukturierung bzw. zur Vorbereitung der Strukturierung des Schablonenmaterials. Der Strukturierungskopf 3 weist eine Belichtungseinrichtung auf, die, wie dargestellt, vorzugsweise bei einen hohen Druckflächenanteil aufweisenden Motiven zur Belichtung des Schablonenmaterials verwendet wird. Bei dem in der einzigen Figur dargestellten Betriebszustand der erfindungsgemäßen Erfindung 1 befindet sich der eine Materialauftragseinrichtung aufweisende Strukturierungskopf 4 in einer seitlichen Ruheposition.

Die relative Verfahrbarkeit zwischen der Siebdruckschablone und den Strukturierungsköpfen 3, 4 wird bei dem dargestellten Ausführungsbeispiel durch zwei ober- und unterhalb des Flachdrucksiebes 2 angeordnete feststehende Führungsschienen 5 und zwei gemeinsam relativ zu den feststehenden Führungsschienen 5 horizontal verschiebbare Führungsschienen 6, auf denen die Strukturierungsköpfe 3 und 4 vertikal verschiebbar angeordnet sind, gewährleistet.

Bei dem in der einzigen Figur dargestellten Ausführungsbeispiel einer erfindungsgemäßen Vorrichtung 1 weist der erste Strukturierungskopf 3 ein im Einzelnen nicht dargestelltes mikromechanisches Spiegelsystem zur Belichtung des Schablonenmaterials auf. In dem in der einzigen Figur dargestellten Betriebszustand wird die Gesamtfläche des Flachdrucksiebes 2 mit dem ersten Strukturierungskopf 3 zur Strukturierung des Schablonenmaterials wie bekannt abgefahren. Der zweite Strukturierungskopf 4, der einen ebenfalls nicht im Einzelnen dargestellten Düsenkopf zum Auftrag von Wachs oder Tinte zur Herstellung einer Belichtungsmaske, also zur Vorbereitung der anschließenden Strukturierung durch Belichtung, auf dem Schablonenmaterial aufweist, befindet sich in dem dargestellten Betriebszustand der erfindungsgemäßen Vorrichtung in einer Ruheposition und wird bei der Herstellung der konkreten Siebdruckschablone nicht eingesetzt.

Wie sich aus der einzigen Figur ohne weiteres ergibt, sind die Strukturierungsköpfe 3, 4 bei dem dargestellten Ausführungsbeispiel nicht auf einer gemeinsamen Halterung angeordnet, sondern getrennt voneinander verschiebbar.

## Patentansprüche

1. Vorrichtung (1) zur Herstellung von Siebdruckschablonen für Drucksiebe (2), insbesondere für Flach- und/oder Runddrucksiebe, mit einer Aufnahme für die Siebdruckschablone und mindestens einem relativ zur Siebdruckschablone verfahrbaren Strukturierungskopf (3, 4), wobei der Strukturierungskopf (3, 4) das Schablonenmaterial der Siebdruckschablone strukturiert oder zumindest für eine Strukturierung vorbereitet,
**dadurch gekennzeichnet, dass**
mindestens zwei Strukturierungsköpfe (3, 4) vorgesehen sind, ein erster Strukturierungskopf (3) eine Belichtungseinrichtung aufweist und ein zweiter Strukturierungskopf (4) eine Materialauftragseinrichtung aufweist.

2. Vorrichtung nach Anspruch 1,
**dadurch gekennzeichnet, dass**
die Belichtungseinrichtung ein mikromechanisches Spiegelsystem aufweist.

3. Vorrichtung nach Anspruch 1 oder 2,
**dadurch gekennzeichnet, dass** die Materialauftragseinrichtung einen Düsenkopf zum Auftrag von Wachs oder Tinte zur Herstellung einer Belichtungsmaske auf dem Schablonenmaterial aufweist.

4. Vorrichtung nach einem der Ansprüche 1 bis 3,
**dadurch gekennzeichnet, dass**
die Strukturierungsköpfe (3, 4) auf einer gemeinsamen Halterung angeordnet sind.

5. Vorrichtung nach einem der Ansprüche 1 bis 4,
**dadurch gekennzeichnet, dass**
die Strukturierungsköpfe (3, 4) auf getrennten Halterungen angeordnet sind.
